# EUROPEAN PATENT SPECIFICATION

(11) **EP 1 867 672 B1**
(45) Date of publication and mention of the grant of the patent: **26.01.2011**
(21) Application number: 06731438.5
(22) Date of filing: 07.04.2006
(51) Int. Cl.: C08G 59/14, C08J 5/24, C08L 63/00

(54) **EPOXY RESIN COMPOSITION**
EPOXIDHARZZUSAMMENSETZUNG
COMPOSITION DE RÉSINE ÉPOXYDE

(30) Priority: 07.04.2005 JP 2005110584
(43) Date of publication of application: 19.12.2007
(73) Proprietor: Asahi Kasei Chemicals Corporation, Tokyo 100-8440 (JP)
(72) Inventor: ARAI, Takeshi, Chiyoda-ku, Tokyo 100-8440 (JP); URAKAWA, Masaaki, Chiyoda-ku, Tokyo 100-8440 (JP)
(74) Representative: HOFFMANN EITLE
(86) International application number: PCT/JP2006/307491
(87) International publication number: WO 2006/109744

(56) References cited:
- EP-A- 1 775 321
- JP-A- 05 043 657
- JP-A- 09 071 634
- JP-A- 09 100 358
- JP-A- 09 143 244
- JP-A- 2000 159 911

## Description

### TECHNICAL FIELD

The present invention relates to an epoxy resin composition excellent in heat resistance and insulation reliability, a prepreg using the same, and further a metal clad laminate formed by laminating the prepreg.

### BACKGROUND ART

Recently, in the field of electronic device materials, as electric appliances have been increasingly functionalized and miniaturized, high-density mounting of LSI and designing of multilayer printed wiring board have been advanced. Particularly, a printed wiring board for semiconductor packaging undergoes steps such as wire bonding of semiconductor chips, resin sealing, and solder reflow at high temperature during a production process thereof. For the material of the printed wiring board for use in such products, a higher glass transition temperature (Tg) as before is required in order to maintain physical properties such as strength and elastic modulus at high temperature. In the case of the printed wiring board for semiconductor packaging and an ultra-multilayer printed wiring board for use in internet communication devices, as a result of remarkable increase of wiring density, malfunction of wiring conductors, particularly copper ionic migration has been becoming a big problem. Thus, also toward the epoxy resin composition to be used as an insulating resin for copper clad laminate, there have been required not only heat resistance and copper foil adhesion strength which have been conventionally required but also hard occurrence of the ion migration. Moreover, recently, in the printed wiring board for electronic devices, the thickness of the insulation layer of the multilayer wiring has been regulated in order to control signal line impedance. Therefore, the resin flow of the prepreg has been usually required to be constant and it has becoming important not to vary gel time of the prepreg during storage after the production, that is, the storage stability of the prepreg has becoming important.

However, it could not be said that heat resistance, adhesiveness, the anti-ion migration property, and the storage stability of the prepreg are not necessarily all exhibited by the method of curing a conventionally employed epoxy resin composition substantially comprising a combination of a lowly brominated epoxy resin, a multifunctional epoxy resin, and the like, with a curing agent such as dicyandiamide or a novolac-type phenol resin and an effect accelerator such as imidazole.

For example, Patent Documents 1 and 2 disclose resin compositions comprising an oxazolidone ring-containing epoxy resin and a brominated epoxy resin. Although the adhesiveness of these resin compositions satisfies a required level but no sufficient effects are exhibited on the glass transition temperature and insulation reliability.

Patent Document 1: JP-A-5-222160
Patent Document 2: JP-A-4-227924

### DISCLOSURE OF THE INVENTION

### PROBLEMS TO BE SOLVED BY THE INVENTION

Under such circumstances, it is an object of the present invention to provide a highly reliable epoxy resin composition excellent in heat resistance, adhesiveness, prepreg storage stability, and insulation reliability.

### MEANS FOR SOLVING THE PROBLEMS

As a result of the extensive studies for solving the above problems, the present inventors have attained the resin composition of the invention.

Namely, the invention is as follows.
(1) An epoxy resin composition comprising (A) an oxazolidone ring-containing epoxy resin, (B) a novolac-type epoxy resin, (C) a guanidine derivative, and (D) an imidazole as components, wherein the component (A) contains an isocyanuric ring as well as an oxazolidone ring and, the IR absorbance ratio of the isocyanuric ring to the oxazolidone ring is not less than 0.01 and not more than 0.1, the weight ratio of the component (A) to the component (B) is 5:95 to 95:5, the content of the component (C) and the content of the component (D) are 0.01 to 5 parts by weight and not more than 0.08 part by weight, respectively, based on 100 parts by weight of the total weight of the epoxy resins containing the component (A) and the component (B), and the bromine content based on a weight obtained by subtracting the weight of the component (C) and the weight of the component (D) from the weight of the resin composition is not less than 10% by weight and not more than 20% by weight.
(2) The epoxy resin composition according to (1), wherein the softening point of the novolac-type epoxy resin of the component (B) is not lower than 80°C.
(3) The epoxy resin composition according to (1), wherein the weight ratio of the component (A) to the component (B) is 40:60 to 95:5.
(4) The epoxy resin composition according to (1), wherein the content of the component (D) is 0.005 to 0.08 part by weight based on 100 parts by weight of the total weight of the epoxy resins containing the component (A) and the component (B).
(5) A prepreg, which is obtained by impregnating a base material with the epoxy resin composition according to (1).
(6) A metal clad laminate, which is formed by laminating the prepreg according to (5) with a metal foil.
(7) A printed wiring board comprising at least one wiring layer, which is produced from the prepreg according to (5) and the metal clad laminate according to (6).

### ADVANTAGES OF THE INVENTION

The composition of the present invention has the advantages of excellent heat resistance, adhesiveness, prepreg storage stability, and insulation reliability as an epoxy resin composition for a multilayer board.

### BEST MODE FOR CARRYING OUT THE INVENTION

The present invention is described in detail below.
In the invention, the (A) oxazolidone ring-containing epoxy resin (hereinafter referred to as component (A)) preferably contains 0.5 to 10 equivalents/kg of oxazolidone rings, and more preferably contains 0.5 to 5 equivalents/kg of an oxazolidone ring. It is preferable to contain at least 0.5 equivalent/kg of an oxazolidone ring because toughness and heat resistance of a cured product can be improved. Also, it is preferable to contain not more than 10 equivalents/kg of oxazolidone rings because water resistance of the cured product can be improved.

The epoxy equivalent of the component (A) is preferably 200 to 10,000 g/eq, more preferably 250 to 5,000 g/eq, and even more preferably 250 to 2,000 g/eq. An epoxy equivalent of not more than 10,000 g/eq is preferable in terms of improving heat resistance and water resistance of the cured product, while an epoxy equivalent of not less than 200 g/eq is preferable in terms of improving toughness of the cured product.

Furthermore, while the component (A) has epoxy groups having an average of one functional group or more per molecule, it preferably has epoxy groups having an average of 1.2 to 5 functional groups, more preferably epoxy groups having an average of 1.2 to 3 functional groups, and further preferably epoxy groups having an average of 2 to 3 functional groups, per molecule. Epoxy groups having not more than 5 functional groups are preferable because heat resistance and storage stability of the cured product improve, while those having not less than 1.2 functional groups are preferable because heat resistance improves.

The component (A) can be obtained in its roughly theoretical amount by, for example, reacting a glycidyl compound with an isocyanate compound in the presence of an oxazolidone ring-forming catalyst. For example, by reacting an isocyanate compound with a glycidyl compound in the range of equivalent ratio of 1:1.1 to 1:10, the oxazolidone ring-containing epoxy resin can be obtained. The equivalent ratio of the isocyanate compound to the glycidyl compound to be used is preferably in the range of 1:1.1 to 1:10 because heat resistance and water resistance can be improved.

Examples of the raw material glycidyl compound to be used in the production of the component (A) include resins comprising glycidyl ethers, glycidyl esters, glycidyl amines, linear aliphatic epoxides, alicyclic epoxides, and/or the like. Examples of the glycidyl ethers include glycidyl ethers of bisphenol or a divalent or multivalnet phenol, novolac polyglycidyl ethers, alkyl glycidyl ethers, and the like. Specific examples of these glycidyl ethers include glycidylated compounds of divalent phenols such as bisphenol A, bisphenol F, bisphenol AD, bisphenol S, tetramethyl bisphenol A, tetramethyl bisphenol F, tetramethyl bisphenol AD, tetramethyl bisphenol S, biphenol, and dihydroxynaphthalene. Further examples include tris(glycidyloxyphenyl)alkanes such as 1,1,1-tris(4-hydroxyphenyl)methane, 1,1,1-(4-hydroxyphenyl)ethane, and 4,4-[1-[4-[1-(4-hydroxyphenyl)-1-methylethyl]phenyl]ethylidene]bisphenol, and glycidylated compounds of amino phenols and the like.
Moreover, examples also include glycidylated compounds of novolacs such as phenol novolac, cresol novolac, bisphenol A novolac and naphthol novolac. Examples of the glycidyl esters include diglycidyl ester of hexahydrophthalic acid, diglycidyl ester of a dimer acid, and the like. Examples of the glycidyl amines include tetraglycidyl-diaminodiphenylmethane, triglycidyl-p-aminophenol, triglycidyl-m-aminophenol, and the like. Examples of the linear aliphatic epoxides include epoxidized polybutadiene, epoxidized soybean oil, and the like.
Examples of the alicyclic epoxides include 3,4-epoxy-6-methylcyclohexyl carboxylate, 3,4-epoxycyclohexyl carboxylate, and the like. These raw material glycidyl compounds may be used singly or in combination of two or more thereof.

Examples of the raw material isocyanate compound used for obtaining the component (A) resin include, but are not limited to, as aliphatic isocyanate compounds, bifunctional isocyanate compounds such as methane diisocyanate, butane-1,1-diisocyanate, ethane-1,2-diisocyanate, butane-1,2-diisocyanate, trans-vinylene diisocyanate, propane-1,3-diisocyanate, butane-1,4-diisocyanate, 2-butene-1,4-diisocyanate, 2-methylbutene-1,4-diisocyanate, 2-methylbutane-1,4-diisocyanate, pentane-1,5-diisocyanate, 2,2-dimethylpentane-1,5-diisocyanate, hexane-1,6-diisocyanate, heptane-1,7-diisocyanate, octane-1,8-diisocyanate, nonane-1,9-diisocyanate, decane-1,10-diisocyanate, dimethylsilane diisocyanate, ω,ω'-1,3-dimethylcyclohexane diisocyanate, ω,ω'-1,4-dimethylcyclohexane diisocyanate, cyclohexane-1,3-diisocyanate, cyclohexane-1,4-diisocyanate, and dicyclohexylmethane-4,4'-diisocyanate and, as aromatic isocyanate compounds, bifunctional isocyanate compounds such as diphenylsilane diisocyanate, ω,ω'-1,3-dimethylbenzene diisocyanate, ω,ω'-1,4-dimethylbenzene diisocyanate, ω,ω'-1,4-dimethylnaphtalene diisocyanate, ω,ω'-1,5-dimethylnaphtalene diisocyanate, 1,3-phenylene diisocyanate, 1,4-phenylene diisocyanate, 1-methylbenzene-2,4-diisocyanate, 1-methylbenzene-2,5-diisocyanate, 1-methylbenzene-2,6-diisocyanate, 1-methylbenzene-3,5-diisocyanate, diphenyl ether-4,4'-diisocyanate, diphenyl ether-2,4'-diisocyanate, naphthalene-1,4-diisocyanate, naphthalene-1,5-diisocyanate, biphenyl-4,4'-diisocyanate, 3,3'-dimethylbiphenyl-4,4'-diisocyanate, 2,3'-dimethoxybiphenyl-4,4'-diisocyanate, diphenylmethane-4,4'-diisocyanate, 3,3'-dimethoxydiphenylmethane-4,4'-diisocyanate, 4,4'-dimethoxydiphenylmethane-3,3'-diisocyanate, diphenyl sulfite-4,4'-diisocyanate, and diphenyl sulfone-4,4'-diisocyanate. Further examples include multifunctional isocyanate compounds such as polymethylene polyphenyl isocyanate, triphenylmethane triisocyanate, and tris(4-phenyl isocyanate thiophosphate)-3,3',4,4'-diphenylmethane tetraisocyanate; multimers, such as dimers or trimers, of the above-described isocyanate compounds; block isocyanate and bisurethane compounds which have been masked with an alcohol or phenol, and the like. These isocyanate compounds may be used singly or in combination of two or more thereof.

Among the above-described raw material isocyanate compounds for the component (A) resin, preferable are bi- or trifunctional isocyanate compounds, and more preferable are bifunctional isocyanate compounds. This is because if the number of functional groups on the isocyanate compound is too large, storage stability decreases, while if the number is too small, heat resistance is not exhibited. Easily-available isocyanate compounds represented by the following formula (1) or (2) are particularly preferable.

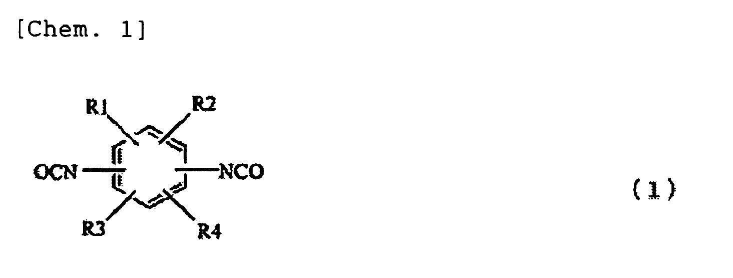

(wherein R1 to R4 are each independently a hydrogen atom or an alkyl group having 1 to 4 carbons)

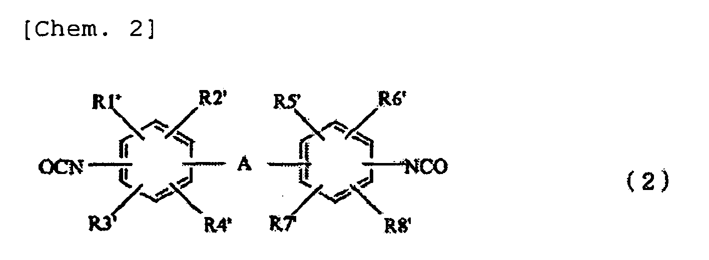

(wherein R1' to R8' are each independently a hydrogen atom or an alkyl group having 1 to 4 carbons; and A is a single bond, -CH₂-, -C(CH₃)₂, -SO₂-, -SO-, -CO-, -S-, or - O-)

Production of the component (A) resin can be conducted, for example, in the presence of an oxazolidone ring-forming catalyst. The oxazolidone ring-forming catalyst, preferable is a catalyst which selectively allows formation of an oxazolidone ring in the reaction of a glycidyl compound with an isocyanate compound.

Examples of the oxazolidone ring-forming catalyst in such a reaction include, but are not limited to, lithium compounds such as lithium chloride and butoxylithium; boron trifluoride complex salts; quaternary ammonium salts such as tetramethylammonium chloride, tetramethylammonium bromide, and tetramethylammonium iodide; tertiary amines such as dimethylaminoethanol, triethylamine, tributylamine, benzyldimethylamine, and N-methylmorpholine; phosphines such as triphenylphosphine; phosphonium compounds such as allyltriphenylphosphonium bromide, diallyldiphenylphosphonium bromide, ethyltriphenylphosphonium chloride, ethyltriphenylphosphonium iodide, tetrabutylphosphonium acetate-acetic acid complexes, tetrabutylphosphonium acetate, tetrabutylphosphonium chloride, tetrabutylphosphonium bromide, and tetrabutylphosphonium iodide; the combination of triphenylantimony and iodine; and imidazols such as 2-phenylimidazol and 2-methylimidazol. They may be used singly or in combination of two or more thereof.

The amount of the oxazolidone ring-forming catalyst to be used is preferably in the range of 5 ppm to 2% by weight of the used raw material. The amount is preferably 10 ppm to 1% by weight, more preferably 20 to 5,000 ppm, and even more preferably 20 to 1,000 ppm. Such amount is preferable because if the catalyst is not more than 2% by weight, the risk of a drop in insulating properties or moisture resistance caused by the catalyst remaining in the formed resin when employed as a laminate material can be avoided. The amount of not less than 5 ppm is preferable because with such amount a drop in the production efficiency for obtaining a given resin can be avoided. To remove the catalyst, the epoxy resin of the invention can be filtered using a suitable solvent in which the catalyst substantially does not dissolve.

The production of the component (A) can also be carried out in the presence of a suitable solvent which can dissolve the component (A). In the case of using a solvent, preferable examples include solvents chemically inert to the component (A), such as N,N-dimethylformamide, N,N-diethylformamide, N-methyl-2-pyrrolidone, dimethylsulfoxide, methyl ethyl ketone, xylene, toluene, methyl cellosolve, and tetrahydrofuran. They may be used singly or in combination of two or more thereof.

The production of the component (A) is not particularly limited and can be, for example, by the following method. A predetermined amount of the raw material epoxy resin is charged into a reaction vessel, and the whole is then heated and regulated at a given temperature. Subsequently, the catalyst is charged therein singly or after being mixed with water or a suitable solvent. The charging is carried out at a temperature range of preferably 20 to 200°C, more preferably 80 to 200°C, and further preferably 110 to 180°C. Charging the catalyst at a temperature of at least 20°C is preferable because a drop in epoxy group concentration, which is caused by the reaction between the epoxy group and the secondary alcohol group in the molecule is promoted until a given reaction temperature is reached, can be avoided. The charging at a temperature of not more than 200°C is preferable because the reaction can be prevented from going out of control.
Next, the above-described isocyanate compound is added dropwise in stages or continuously all at once or broken up into several times. The time for dropwise addition is preferably carried out over a period of preferably 1 to 10 hours, more preferably 2 to 5 hours. This is because excessive formation of the isocyanuric ring is sometimes promoted when the time for dropwise addition is shorter than 1 hour, while the concentration of the epoxy group sometimes decreases when the time for dropwise addition is longer than 10 hours, so that in either case the qualities and storage stability of the obtained resin deteriorate.

Although the reaction is typically carried out in a temperature range of 20 to 300°C, the reaction is carried out in a temperature range of preferably 60 to 250°C, more preferably 120 to 230°C, even more preferably 140 to 220°C, and especially preferably 140 to 200°C. By setting the temperature to not higher than 300°C, deterioration in the resin can be prevented, while by setting to not lower than 20°C, the reaction is sufficiently completed, whereby the formation of a resin comprising a large amount of undesirable triisocyanuric rings can be prevented, so that in either case the storage stability and water resistance of the obtained resin are improved.

During the production of the component (A) with a glycidyl compound and an isocyanate compound, a phenolic compound may be added. Examples of the phenolic compound include bisphenol A, bisphenol F, bisphenol AD, bisphenol S, tetramethyl bisphenol A, tetramethyl bisphenol F, tetramethyl bisphenol AD, tetramethyl bisphenol S, tetrabromo bisphenol A, tetrachloro bisphenol A, tetrafluoro bisphenol A, biphenol, dihydroxynaphthalene, tris(glycidyloxyphenyl)alkanes such as 1,1,1-tris(4-hydroxyphenyl)methane, 1,1,1-(4-hydroxyphenyl)ethane, and 4,4-[1-[4-[1-(4-hydroxyphenyl)-1-methylethyl]phenyl]ethylidene]bisphenol, amino phenols, phenol novolac, cresol novolac, bisphenol A novolac, naphthol novolac, brominated phenol novolac, brominated bisphenol A novolac, and the like. They may be added singly or in combination of two or more thereof.

In the resin composition of the invention, the ratio of the absorbance at an isocyanuric ring-derived wavenumber of 1,710 cm⁻¹ by infrared spectrophotometry to the absorbance at an oxazolidone ring-derived wavenumber of 1,750 cm⁻¹ of the component (A) is preferably not less than 0.01 and not more than 0.1. When the IR absorbance ratio is not less than 0.01, the necessary amount of the imidazole in the resin composition of the invention can be reduced, while the IR absorbance ratio is not more than 0.1, prepreg storage stability and water resistance of the cured product are excellent. The IR absorbance ratio is most preferably not less than 0.02 and not more than 0.05.

Moreover, the component (A) preferably contains a glycidyl compound. More preferably, it is preferable for the unreacted compound of the raw material glycidyl compound to remain. Furthermore, the unreacted compound of the raw material glycidyl compound is preferably a monomer component. When the glycidyl compound has repeating units, the term "monomer component" refers to one unit of the repeating units, while the glycidyl compound has no repeating units, it refers to the glycidyl compound itself. In the case of bisphenol A diglycidyl ether, for example, the bisphenol A diglycidyl ether is represented by the following formula (3) and the term "monomer component" refers to a component wherein n=0 in the formula.

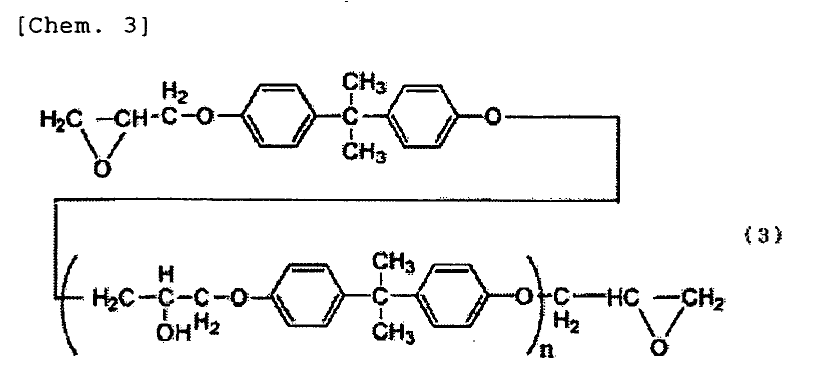

wherein n is 0 or a positive integer.

The component (A) preferably contains 5 to 80% by weight, more preferably 10 to 60% by weight, even more preferably 15 to 50% by weight, and especially preferably 20 to 40% by weight of unreacted monomer component of the raw material glycidyl compound. When the content is not less than 5% by weight, there is observed no decrease in curing reaction rate caused by lowering of the concentration of the glycidyl groups, while when the content is not more than 80% by weight, the oxazolidone ring concentration can be increased and hence the heat resistance of the cured product is improved.

As the (B) novolac-type epoxy resin in the resin composition according to the invention (hereinafter referred to as component (B)), a compound having a novolac-type structure in the molecule is used. Examples thereof include phenol novolac-type epoxy resins, cresol novolac-type epoxy resins, naphthol novolac-type epoxy resins, bisphenol A novolac-type epoxy resin, and the like. In particular, a resin having a softening point of not lower than 80°C is preferred in view of exhibiting an effect of excellent prepreg storage stability. Of these, from the viewpoint of the balance of Tg and toughness of the cured product, and prepreg storage stability, a cresol novolac-type epoxy resin of the following formula (4) is particularly preferred. They are used singly or in combination of two or more thereof but the component (B) is not limited thereto.

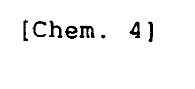

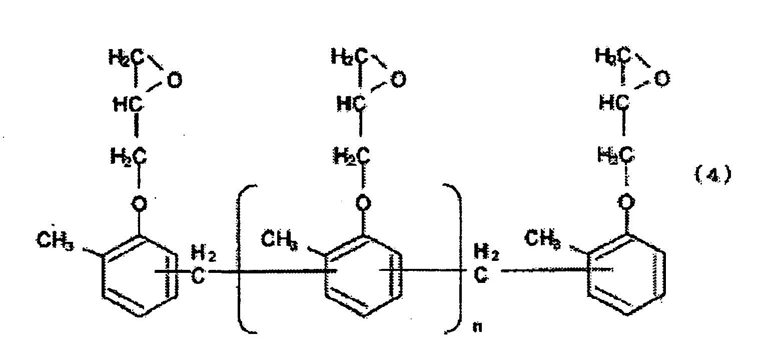

(wherein n is 0 or a positive integer.)

The weight ratio of the component (A) to the component (B) in the epoxy resin composition is preferably in the range of 5:95 to 95:5, more preferably in the range of 50:50 to 90:10, and most preferably 60:40 to 80:20. In the preferable composition range, not only a useful cured product excellent in adhesion strength and insulation reliability is obtained but also storage stability and insulation reliability of a prepreg are excellent. Namely, when the weight ratio of the component (A) is not less than 5, the concentration of the oxazolidone ring in the epoxy resin is sufficient and the adhesion strength is high. When the ratio is not more than 95, the mixing ratio of the novolac-type epoxy resin is sufficient, Tg of the cured product is high, and a rate of the curing reaction is sufficiently fast, so that the amount of the imidazole used can be reduced. Moreover, when the weight ratio of the component (B) exceeds 95, the gel time of the resin composition becomes too short and thus the forming property sometimes gets worse.

In the resin composition of the invention, the (C) guanidine derivative (hereinafter referred to as component (C)) is a compound having a structure of the following formula (5).

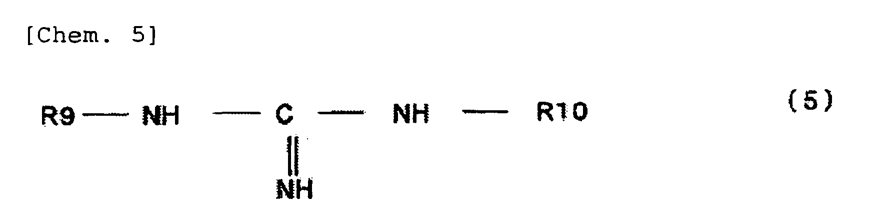

wherein R9 and R10 are substituents and the structures thereof are not particularly limited but examples thereof include hydrogen, alkyl groups, alkenyl groups, alkynyl groups, aryl groups, heterocyclic ring groups, a cyano group, a nitro group, and combinations thereof.

Specific examples of guanidine derivatives include dicyandiamide, dicyandiamide derivatives such as dicyandiamide-aniline adducts, dicyandiamide-methylaniline adducts, dicyandiamide-diaminodiphenylmethane adducts, dicyandiamide-dichlorodiaminodiphenylmethane adducts, and dicyandiamide-diaminodiphenyl ether adducts, guanidine salts such as aminoguanidine hydrochloride, guanidine hydrochloride, guanidine nitrate, guanidine carbonate, guanidine phosphate, guanidine sulfaminate, and aminoguanidine bicarbonate; acetylguanidine, diacetylguanidine, propionylguanidine, dipropionylguanidine, cyanoacetylguanidine, guanidine succinate, guanidine maleate, guanidine butyrate, guanidine adipate, guanidine phthalate, diethylcyanoacetylguanidine, dicyandiamidine, N-oxymethyl-N'-cyanoguanidine, N,N'-dicarboethoxyguanidine, chloroguanidine, bromoguanidine, o-toluylbiguanide, and the like. More preferable are dicyandiamide and guanidine maleate, and most preferable is dicyandiamide. They may be used in combination of two or more thereof. Moreover, if necessary, they may be used as an adduct with an epoxy group-containing compound.

The amount of the component (C) to be used is 0.01 to 5 parts by weight, preferably 0.05 to 4 parts by weight, and more preferably 0.1 to 3 parts by weight based on 100 parts by weight of the total weight of the epoxy resins containing the component (A) and the component (B). When the ratio of the component (C) used is less than 0.01 part by weight based on 100 parts by weight of the total weight of the epoxy resins containing the component (A) and the component (B), adhesion strength to the metal foil or the oxidatively treated surface of the metal foil tends to be insufficient. When the ratio exceeds 5 parts by weight, the solder heat resistance may sometimes decrease. In the preferable mixing amount range of the component (C), a strong adhesion strength can be obtained without impairing the excellent heat resistance of the cured product owing to the component (C).

The imidazole as the component (D) of the resin composition of the invention is used as a curing accelerator of the component (C). As the component (D), 2-methylimidazole, 2-ethyl-4-methylimidazole, 2-phenylimidazole, and the like may be mentioned. When the amount of the component (D) to be added is not more than 0.08 part by weight based on 100 parts by weight of the total weight of the epoxy resins containing the component (A) and the component (B), the storage stability and insulation reliability of the prepreg can be enhanced. Moreover, when the amount is not less than 0.005 part by weight, the glass transition temperature of the cured product can be sufficiently improved, and hence the case is preferred.

The bromine content of the resin composition of the invention is not less than 10% by weight and not more than 20% by weight, most preferably not less than 12% by weight and not more than 18% by weight. When the bromine content is less than 10% by weight, the flame retardance of the laminate containing the cured product and the base material tends to be insufficient. When the content exceeds 20% by weight, the thermal decomposition temperature of the printed wiring board comprising the resin composition of the invention is lowered and thus it becomes difficult to use a high melting point solder such as a lead-free solder.

As a method of incorporating bromine into the resin composition of the invention, any known methods can be employed but a method of mixing a brominated epoxy resin is preferable because the glass transition temperature of the cured product of the resulting resin composition increases. As the brominated epoxy resin, for example, a compound represented by the following formula (6) which is generally known as a highly brominated epoxy resin (bromine content of about 49% by weight) may be mentioned.

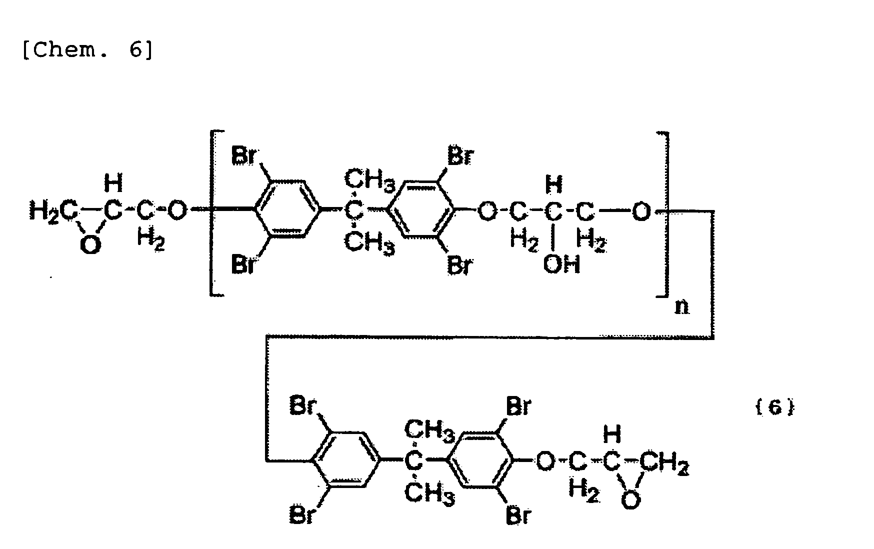

(wherein n is 0 or a positive integer.)

The hydrolyzable chlorine content in the residual components when the component (C) and the component (D) are subtracted from the resin composition of the invention is preferably not more than 500 ppm, more preferably not more than 200 ppm, even more preferably not more than 100 ppm, especially preferably not more than 50 ppm, and most preferably not more than 30 ppm. This is because when the amount of hydrolyzable chlorine is more than 500 ppm, the metal conductor used in the wiring board is corroded, whereby a drop in insulating properties may occur.

"Hydrolyzable chlorine content" is a value determined as follows: 3 g of a sample is dissolved in 25 ml of toluene, then 20 ml of a 0.1 N KOH-methanol solution is added to the resultant mixture. This solution is boiled for 15 minutes and subjected to silver nitrate titration. In the same manner, the sample is dissolved in toluene, and then titered as it is with silver nitrate. The inorganic chlorine content obtained by titration is subtracted from the former titration value to determine the objective value.

A curing accelerator other than imidazole can be added to the resin composition of the invention, if necessary. The kind of the curing accelerator is not particularly limited but examples thereof include tertiary amines, phosphines, aminotriazoles, and the like.

Moreover, for the purpose of imparting desired properties without impairing the advantages of the invention, any epoxy resin can be added to the resin composition of the invention.

The resin composition of the invention can be prepared in the form of an epoxy resin varnish by dissolving or dispersing individual components in a solvent. The solvent is not particularly limited and acetone, methyl ethyl ketone, methyl cellosolve, methyl isobutyl ketone, dimethylformamide, methanol, and the like can be used. The solvent is selected based on the properties of the epoxy resin, the curing agent, the curing accelerator, and the other additives.

For the purpose of imparting desired performance depending on the uses, a filler and additives can be mixed with the resin composition of the invention in amounts which do not impair intrinsic nature thereof. The filler may be fibrous or powdery and examples thereof may include silica, alumina, talc, mica, glass beads, glass hollow spheres, and the like. As the additives, there may be mentioned an antioxidant, a thermal stabilizer, an antistatic agent, a plasticizer, a pigment, a dye, a colorant, and the like.

A base material may be added to the resin composition of the invention in order to increase mechanical strength and dimensional stability. Examples of base materials to be used in the present invention include various glass cloths such as rubbing cloth, cloth, chopped mats, and surfacing mats; asbestos cloth, metal fiber cloth and other synthetic or natural inorganic fiber cloths; woven or non-woven cloths obtained from synthetic fibers such as polyvinyl alcohol fiber, polyester fiber, acrylic fiber, wholly aromatic polyamide fiber and polytetrafluoroethylene fiber; natural fiber cloths such as cotton cloth, hemp cloth and felt; carbon fiber cloths; and natural cellulose cloths such as Kraft paper, cotton paper and paper-glass mixed fiber paper. Each of these may be used singly or in combination of two or more thereof. Furthermore, the base material may also be formed by adding organic and/or inorganic short fibers to the resin composition.

Examples of the method for producing the prepreg of the invention include a method of uniformly dissolving or dispersing the resin composition of the invention and other components as necessary into the above-described solvent or mixed solvent thereof, impregnating a base material with the resultant solution and then drying. When drying, it is preferable for the resin composition to be in a semi-cured state, or so-called "B stage", by regulating the heating level.

Impregnation can be carried out by dipping, coating or other such technique. If necessary, the impregnation can be repeated multiple times. The impregnation can also be repeated using a plurality of solutions having different compositions or concentrations, to thereby adjust to the ultimately-desired resin composition or resin amount.

The prepreg of the invention may use a coupling agent as necessary to improve adhesiveness at the surface boundary between the resin and the base material. As the coupling agent, common agents such as silane coupling agents, titanate coupling agents, aluminum coupling agents, zircoaluminate coupling agents can be employed.

The ratio of the base material in the prepreg of the invention is, based on 100 parts by weight of the prepreg, preferably 5 to 90% by weight, more preferably 10 to 80% by weight, and further preferably 20 to 70% by weight. When the ratio of the base material is not less than 5% by weight, the dimensional stability and strength of the composite material after curing is sufficient, while when the ratio of the base material is not more than 90% by weight, dielectric properties and flame retardance of the cured prepreg product are excellent and thus the cases are preferable.

The metal clad laminate according to the invention is produced by laminating and curing a metal foil and the prepreg. The lamination and curing can be conducted, for example, at a temperature of 80 to 300°C, under a pressure of 0.01 to 100 MPa, for a period of time ranging 1 minute to 10 hours, and more preferably at a temperature of 120 to 250°C, under a pressure of 0.1 to 10 MPa, for a period of time ranging 1 minute to 5 hours.

Examples of the metal foil to be used in the metal-clad laminate of the invention include copper foil, aluminum foil, tin foil, and the like. Copper foil is especially preferable. The thickness is not especially limited, but is preferably in a range of 5 to 200 µm and more preferably 5 to 105 µm.

### EXAMPLES

The present invention will be illustrated in greater detail with reference to Production Examples, Examples, and Comparative Examples. Here, the terms "parts" and "%" refer to "parts by weight" and "% by weight", respectively.

### (Production Example 1)

One hundred parts of bisphenol A-type epoxy resin (epoxy equivalent of 189 g/eq) were charged with 0.04 part of tetrabutylammonium bromide. The resultant solution was heated under stirring to an internal temperature of 175°C. The solution was further charged over a period of 120 minutes with 16.1 parts of Coronate T-80 (TDI, manufactured by Nippon Polyurethane Industry Co., Ltd.; approximately 80% of 2,4-tolylene diisocyanate, approximately 20% of 2,6-tolylene diisocyanate). After the charging was completed, the resultant solution was stirred for 4 hours while maintaining the reaction temperature at 175°C, to thereby obtain an oxazolidone ring-containing epoxy resin I. The epoxy equivalent thereof was 334. When the IR absorption spectrum of the oxazolidone ring-containing epoxy resin I was investigated, the absorption peak derived from isocyanate was absent and the IR absorbance ratio of the isocyanuric ring to the oxazolidone ring was 0.03.

### (Production Example 2)

One hundred parts of bisphenol A type epoxy resin (epoxy equivalent of 180 g/eq) were charged with 0.044 part of 2-phenylimidazole. The resultant solution was heated under stirring to an internal temperature of 160°C. The solution was further charged over a period of 45 minutes with 25.0 parts of Millionate MT (MDI, manufactured by Nippon Polyurethane Industry Co., Ltd.; 4,4'-diphenylmethane diisocyanate). After the charging was completed, the temperature of the reaction product was elevated to 180 to 185°C by reaction heat. After the charging with Millionate MT was completed, the resultant solution was stirred for 15 minutes to thereby obtain an oxazolidone ring-containing epoxy resin II. The epoxy equivalent thereof was 345. When the IR absorption spectrum of the oxazolidone ring-containing epoxy resin II was investigated, the absorption peaks derived from isocyanate and isocyanuric ring were absent and the IR absorbance ratio of the isocyanuric ring to the oxazolidone ring was 0.

### (Example 1)

An epoxy resin varnish was prepared by dissolving 48 parts of the oxazolidone ring-containing epoxy resin I obtained in Production Example 1, 34 parts of a highly brominated epoxy resin AER8018 (epoxy equivalent of 334, bromine content of 48.8%) manufactured by Asahi Kasei Chemicals Corporation, 18 parts of a cresol novolac-type epoxy resin ECN1299 (epoxy equivalent of 217) manufactured by Asahi Kasei Chemicals Corporation, 3.1 parts of dicyandiamide (Dicy), and 0.04 part of 2-methylimidazole (2Mz) in a mixed solvent of methoxypropanol and N,N'-dimethylformamide in a weight ratio of 1:1. Gel time of the epoxy resin varnish was 270 seconds at 170°C. The varnish was used to impregnate a glass cloth (manufactured by Asahi-Schwebel Co., Ltd., Styles 7628, 2116, or 1080, Treatment AS 891AW), and the cloth was dried at 170°C to thereby obtain a prepreg having a resin content of about 43% for style 7628, a resin content of about 48% for style 2116, or a resin content of about 60% for style 1080. Gel time of these prepregs was 120 seconds at 170°C. A four layer printed wiring board having plated through-holes of a 0.3 mm diameter was obtained in a usual manner using 3 piles of the prepregs of style 1080 as inner layer material, the prepreg of style 2116 for outer layer adhesion, and 3EC-III copper foil of 12 µ manufactured by Mitsui Mining And Smelting Co., Ltd. for conductor wiring formation. A glossy surface of the inner layer copper foil was subjected to a black oxide treatment with a known oxidizing agent. The plated through-holes were alternatively connected to wirings at a positive terminal side and at a negative terminal side, so that insulation distance between the plated through-hole at the positive terminal side and the plated through-hole at the negative terminal side was 0.3 mm. At the preparation of the printed wiring board, in the case of pressing, the stacks were heated under pressure under conditions of a temperature of 180°C, a pressure of 4 MPa, and a time of 60 minutes. A direct-current voltage of 100 V was imparted by means of a constant-voltage source between the through-hole at the positive terminal side and the through-hole at the negative terminal side of the 4-layered printed wiring board. Thus, when a time until insulation between the through-holes was broken and a short-circuit was formed (insulation reliability) was measured at a temperature of 120°C and a humidity of 85% (2 atm), it was found to be about 4 hours. Moreover, on the 4-layered printed wiring board, measurement of Tg by differential scanning calorimetry (DSC method, DSC 220C manufactured by Seiko Instruments Inc.), measurement of copper foil adhesion strength of the outer layer, and measurement of adhesion strength of the inner layer black oxide treatment were performed. The measurement of adhesion strength was performed in accordance with JIS C6481. Tg was so high as 178°C and the copper foil adhesion strength of the outer layer and the adhesion strength of the inner layer black oxide treatment were high enough as 1.6 kN/m and 0.7 kN/m, respectively. Furthermore, when a test for flame retardance was performed on a laminate having a thickness of about 0.8 mm, which had been obtained by heating under pressure 4 piles of the prepregs of style 7628 under similar conditions, in accordance with UL 94 standard, the laminate showed a good flame retardance corresponding to V-0. When the prepreg of style 7628 was stored at a temperature of 23°C and a humidity of 50% for 90 days and it was investigated how the gel time of the prepreg at 170°C changed from its initial value of 120 seconds, the prepreg showed storage stability as excellent as 92% of the initial value.

### (Comparative Example 1)

An epoxy resin varnish was prepared by dissolving 66 parts of the oxazolidone ring-containing epoxy resin I obtained in Production Example 2, 34 parts of a highly brominated epoxy resin AER8018 (epoxy equivalent of 334, bromine content of 48.8%) manufactured by Asahi Kasei Chemicals Corporation, 2.9 parts of dicyandiamide, 0.35 part of 2-methylimidazole, and 0.24 part of boric acid in a mixed solvent of methoxypropanol and N,N'-dimethylformamide in a weight ratio of 1:1. Gel time of the epoxy resin varnish was 270 seconds at 170°C. Thereafter, a prepreg, a 4-layered wiring board, and a laminate having a thickness of 0.8 mm were prepared in the same manner as in Example 1. Gel time of the prepreg was 120 seconds at 170°C. The insulation reliability was 1.7 hours and was remarkably short, i.e., shorter than one half of the corresponding value as compared with the case in Example 1.

### (Examples 2 to 5 and Comparative Examples 2 to 5)

Epoxy resin varnishes were prepared with formulations shown in Table 1 and prepregs, laminates, and 4-layered wiring boards were prepared in the same manner as in Example 1. Then, the insulation reliability, glass transition temperature, copper foil adhesion strength of the outer layer, adhesion strength of the inner layer black oxide treatment, flame retardance, and storage stability of the prepregs were investigated. In Examples 2 to 5, prepregs excellent in storage stability, laminates having a Tg as excellent as not lower than 170°C, and 4-layered boards excellent in insulation reliability were obtained.

In Comparative Examples 1, 2, and 3 wherein an isocyanuric ring is absent in the oxazolidone ring-containing epoxy resin and the amount of an imidazole used increases, a sufficient insulation reliability is not obtained. Moreover, in Comparative Example 4 wherein the oxazolidone ring-containing epoxy resin is not used, the storage stability of the prepreg and Tg are remarkably inferior to Examples. Furthermore, in Comparative Example 5 wherein the ratio of the oxazolidone ring-containing epoxy resin to the multifunctional resin is too small, the gel time becomes too short, the storage stability of the prepreg is insufficient, the adhesion strength of the outer layer and inner layer copper foils is low, and the forming ability is bad, so that a 4-layered substrate of a good quality could not be obtained.

The results for these Examples are shown in Table 1, and those for these Comparative Examples are shown in Table 2.

**[Table 1]**

| | Unit | Example 1 | Example 2 | Example 3 | Example 4 | Example 5 |
|---|---|---|---|---|---|---|
| Epoxy I | part by weight | 48 | 60 | 48 | 30 | 56 |
| Epoxy II | | | | | | |
| ECN1299^{*1} | | 18 | 6 | | 36 | 5 |
| Epikotel57S65^{*2} | | | | 18 | | |
| EPON1031^{*3} | | | | | | 5 |
| AER8018^{*4} | | 34 | 34 | 34 | 34 | 34 |
| AER8011^{*5} | | | | | | |
| Dicy^{*6} | | 3.1 | 3.1 | 3.1 | 3.4 | 3.3 |
| 2Mz^{*7} | | 0.04 | | | | |
| 2E4Mz^{*8} | | | 0.07 | | | |
| 2Pz^{*9} | | | | 0.04 | 0.005 | 0.04 |
| Boric acid | | | | | | |
| Bromine content | % | 16.7 | 16.7 | 16.7 | 16.7 | 16.7 |
| Weight ratio of (A):(B) | | 73:27 | 91:9 | 73:27 | 45:55 | 92:8 |
| Gel time | second | 270 | 270 | 270 | 260 | 270 |
| Storage stability^{*10} | | 92 | 95 | 88 | 90 | 94 |
| Tg | °C | 178 | 175 | 181 | 181 | 182 |
| Flame retardance (UL94) | | V-0 | V-0 | V-0 | V-0 | V-0 |
| Outer layer adhesion strength | kN/m | 1.6 | 1.7 | 1.6 | 1.3 | 1.7 |
| Inner layer adhesion strength | kN/m | 0.7 | 0.8 | 0.7 | 0.6 | 0.8 |
| Insulation reliability"¹¹ | | A | A | A | A | A |

**[Table 2]**

| | Unit | Comparative Example 1 | Comparative Example 2 | Comparative Example 3 | Comparative Example 4 | Comparative Example 5 |
|---|---|---|---|---|---|---|
| Epoxy I | part by weight | | | | | 0.5 |
| Epoxy II | | 66 | 63 | 63 | | |
| ECN1299^{*1} | | | 5 | | 10 | 63.5 |
| Epikote157S65^{*2} | | | | 5 | | |
| EPON1031^{*3} | | | | | | |
| AER8018^{*4} | | 34 | 32 | 32 | | 36 |
| AER8011^{*5} | | | | | 90 | |
| Dicy^{*6} | | 2.9 | 3.2 | 2.9 | 2.7 | 4.6 |
| 2Mz^{*7} | | 0.35 | 0.10 | 0.14 | | |
| 2E4Mz^{*8} | | | | | 0.05 | |
| 2Pz^{*9} | | | | | | |
| Boric acid | | 0.24 | | | | |
| Bromine content | % | 16.6 | 15.6 | 15.6 | 18.5 | 17.6 |
| Weight ratio of (A):(B) | | 100:0 | 93:7 | 93:7 | 0:100 | 0.1:99.9 |
| Gel time | second | 270 | 270 | 270 | 270 | 180 |
| Storage stability^{*10} | | 91 | 90 | 89 | 80 | 74 |
| Tg | °C | 178 | 172 | 171 | 140 | 190 |
| Flame retardance (UL94) | | V-0 | V-0 | V-0 | V-0 | V-0 |
| Outer layer adhesion strength | kN/m | 1.6 | 1.5 | 1.6 | 1.8 | 0.9 |
| Inner layer adhesion strength | kN/m | 0.8 | 0.7 | 0.7 | 0.8 | 0.2 |
| Insulation reliability^{*11} | | B | B | B | A | A |

| | | | | | | |
|---|---|---|---|---|---|---|
| *1: Cresol novolac-type epoxy resin (manufactured by Asahi Kasei Chemicals Corporation, epoxy equivalent of 219 g/eq, softening point of 92°C) *2: Bisphenol A novolac-type epoxy resin (manufactured by Japan Epoxy Resin Co., Ltd., epoxy equivalent of 213 g/eq, softening point of 65°C) *3: Tetraphenylolethane-type epoxy resin (manufactured by Japan Epoxy Resin Co., Ltd., epoxy equivalent of 213 g/eq) *4: Highly brominated epoxy resin (manufactured by Asahi Kasei Chemicals Corporation, epoxy equivalent of 406, bromine content of 48.8%) *5: Lowly brominated epoxy resin (manufactured by Asahi Kasei Chemicals Corporation, epoxy equivalent of 469 g/eq, bromine content of 20.5%) *6: Dicyandiamide (manufactured by Wako Pure Chemical Industries, Ltd.) *7: 2-Ethyl-4-methylimidazole (manufactured by Wako Pure Chemical Industries, Ltd.) *8: 2-Methylimidazole (manufactured by Wako Pure Chemical Industries, Ltd.) *9: 2-Phenylimidazole (manufactured by Wako Pure Chemical Industries, Ltd.) *10: Retention ratio of gel time when the prepreg of style 7628 was stored at 23°C under a relative humidity of 50% for 90 days *11: Insulation retention time of not less than 2 hours was rated as "A", and that of less than 2 hours was rated as "B". | | | | | | |

While the invention has been described in detail and with reference to specific embodiments thereof, it will be apparent to one skilled in the art that various changes and modifications can be made therein without departing from the spirit and scope thereof.
The present application is based on Japanese Patent Application No. 2005-110584 filed on April 7, 2005, and the contents thereof are herein incorporated by reference.

### INDUSTRIAL APPLICABILITY

The prepregs comprising the resin composition of the invention shows such excellent storage stability as not less than 90%. From the prepregs, laminates or printed wiring boards excellent in copper foil adhesion strength of the outer layer, adhesion strength of the inner layer black oxide treatment, and flame retardance can be obtained. It is obvious that the laminates or printed wiring boards not only have such high Tg as 170°C or higher but also possess excellent insulation reliability. Thus, they are useful in the production of a multilayer printed wiring board for a broadband communications device.

## Claims

1. An epoxy resin composition comprising (A) an oxazolidone ring-containing epoxy resin, (B) a novolac-type epoxy resin, (C) a guanidine derivative, and (D) an imidazole as components, wherein the component (A) contains an isocyanuric ring as well as an oxazolidone ring and, the IR absorbance ratio of the isocyanuric ring to the oxazolidone ring is not less than 0.01 and not more than 0.1, the weight ratio of the component (A) to the component (B) is 5:95 to 95:5, the content of the component (C) and the content of the component (D) are 0.01 to 5 parts by weight and not more than 0.08 part by weight, respectively, based on 100 parts by weight of the total weight of the epoxy resins containing the component (A) and the component (B), and the bromine content based on a weight obtained by subtracting the weight of the component (C) and the weight of the component (D) from the weight of the resin composition is not less than 10% by weight and not more than 20% by weight.

2. The epoxy resin composition according to claim 1, wherein the softening point of the novolac-type epoxy resin of the component (B) is not lower than 80°C.

3. The epoxy resin composition according to claim 1, wherein the weight ratio of the component (A) to the component (B) is 40:60 to 95:5.

4. The epoxy resin composition according to claim 1, wherein the content of the component (D) is 0.005 to 0.08 part by weight based on 100 parts by weight of the total weight of the epoxy resins containing the component (A) and the component (B).

5. A prepreg, which is obtained by impregnating a base material with the epoxy resin composition according to claim 1.

6. A metal clad laminate, which is formed by laminating the prepreg according to claim 5 with a metal foil.

7. A printed wiring board comprising at least one wiring layer, which is produced from the prepreg according to claim 5 and the metal clad laminate according to.claim 6.

## Patentansprüche

1. Epoxyharzzusammensetzung, die folgende Komponenten umfasst: (A) ein Oxazolidonring-haltiges Epoxyharz, (B) ein Novolaktyp-Epoxyharz, (C) ein Guanidinderivat und (D) ein Imidazol, wobei die Komponente (A) sowohl einen Isocyanursäurering als auch eine Oxazolidonring enthält und das IR-Extinktionsverhältis des Isocyanursäurerings zum Oxazolidonring nicht geringe als 0,01 und nicht mehr als 0,1 ist, das Gewichtsverhältnis der Komponente (A) zur Komponente (B) 5:95 bis 95:5 ist, der Gehalt der Komponente (C) und der Gehalt der Komponente (B) jeweils 0,01 bis 5 Gew.-Teile und nicht mehr als 0,08 Gew.-Teile sind bezogen auf 100 Gew.-Teile des Gesamtgewichts der in der Komponente (A) und der Komponente (B) enthaltenen Epoxyharze und der Bromgehalt bezogen auf ein Gewicht, das durch Subtraktion des Gewichts der Komponenten (C) und des Gewichts der Komponente (D) von dem Gewicht der Harzzusammensetzung erhalten wird, nicht geringer als 10 Gew.% und nicht mehr als 20 Gew.% ist.

2. Epoxyharzzusammensetzung gemäß Anspruch 1, wobei der Erweichungspunkt des Novolaktyp-Epoxyharzes der Komponente (B) geringer ist als 80°C.

3. Epoxyharzzusammensetzung gemäß Anspruch 1, wobei das Gewichtsverhältnis der Komponente (A) zur Komponente (B) 40:60 bis 95:5 ist.

4. Epoxyharzzusammensetzung gemäß Anspruch 1, wobei der Gehalt der Komponente (D) 0,005 bis 0,08 Gew.-Teile bezogen auf 100 Gew.-Teile des Gesamtgewichts der in der Komponente (A) und der Komponente (B) enthaltenen Epoxyharze ist.

5. Prepreg, das durch Imprägnieren eines Basismaterials mit der Epoxyharzzusammensetzung gemäß Anspruch 1 erhältlich ist.

6. Metall-verkleidetes Laminat, das durch Laminieren des Prepregs gemäß Anspruch 5 mit einer Metallfolie gebildet ist.

7. Gedruckte Leiterplatte, die mindestens eine Leiterschicht umfasst, die aus dem Prepreg gemäß Anspruch 5 und dem Metall-verkleideten Laminat gemäß Anspruch 6 hergestellt ist.

## Revendications

1. Composition de résine époxy comprenant en tant que composants (A) une résine époxy contenant un cycle oxazolidone, (B) une résine époxy de type novolaque, (C) un dérivé de la guanidine, et (D) un composant imidazole, dans laquelle le composant (A) contient un cycle isocyanurique ainsi qu'un cycle oxazolidone et, le taux d'absorption IR du cycle isocyanurique au cycle oxazolidone n'est pas inférieur à 0,01 et pas supérieur à 0,1, le rapport pondéral du composant (A) au composant (B) est de 5:95 à 95:5, la teneur du composant (C) et, respectivement, la teneur du composant (D) se situe entre 0,01 et 5 parties en poids et pas plus de 0,08 partie en poids, sur base de 100 parties en poids du poids total des résines époxy contenant le composant (A) et le composant (B), et la teneur en brome, sur base d'un poids obtenu en soustrayant le poids du composant (C) et le poids du composant (D) du poids de la composition de résine, n'est pas inférieure à 10 % en poids et ne dépasse pas 20 % en poids.

2. Composition de résine époxy selon la revendication 1, dans laquelle le point de ramollissement de la résine époxy de type novolaque du composant (B) n'est pas inférieur à 80 °C.

3. Composition de résine époxy selon la revendication 1, dans laquelle le rapport pondéral du composant (A) au composant (B) est de 40:60 à 95:5.

4. Composition de résine époxy selon la revendication 1, dans laquelle la teneur du composant (D) est de 0,005 à 0,08 partie en poids sur base de 100 parties en poids du poids total des résines époxy contenant le composant (A) et le composant (B).

5. Préimprégné, qui est obtenu par imprégnation d'un matériau de base avec la composition de résine époxy selon la revendication 1.

6. Stratifié à gaine métallique, qui est formé par stratification du préimprégné selon la revendication 5 avec une feuille de métal.

7. Carte de câblage imprimé comprenant au moins une couche de câblage, qui est produite à partir du préimprégné selon la revendication 5 et du stratifié à gaine métallique selon la revendication 6.
